Europäisches Patentamt

European Patent Office

Office européen des brevets

(19)

(11) **EP 0 819 314 B1**

(12) **FASCICULE DE BREVET EUROPEEN**

(45) Date de publication et mention
de la délivrance du brevet:
**22.08.2001 Bulletin 2001/34**

(51) Int Cl.7: **H01J 37/32**

(21) Numéro de dépôt: **96912076.5**

(86) Numéro de dépôt international:
**PCT/FR96/00524**

(22) Date de dépôt: **05.04.1996**

(87) Numéro de publication internationale:
**WO 96/31898 (10.10.1996 Gazette 1996/45)**

(54) **PROCEDE ET DISPOSITIF POUR LE CONTROLE DE L'ENERGIE DE L'UNE AU MOINS DES ESPECES CHARGEES BOMBARDANT UN CORPS PLONGE DANS UN PLASMA**

VERFAHREN UND VORRICHTUNG ZUR ENERGIESTEUERUNG MINDESTENS EINER DER LADUNGSTRÄGERSORTEN, DIE EINEN IN EIN PLASMA GEBRAUCHTEN KÖRPER BOMBARDIEREN

METHOD AND DEVICE FOR CONTROLLING THE ENERGY OF AT LEAST ONE CHARGED SPECIES BOMBARDING A BODY IMMERSED IN A PLASMA

(84) Etats contractants désignés:
**BE CH DE FR GB IT LI NL**

(30) Priorité: **07.04.1995 FR 9504429**

(43) Date de publication de la demande:
**21.01.1998 Bulletin 1998/04**

(73) Titulaire: **CENTRE NATIONAL DE LA RECHERCHE SCIENTIFIQUE**
**75016 Paris Cédex (FR)**

(72) Inventeurs:
• **PELLETIER, Jacques, H.**
**F-38400 Saint-Martin-d'Hères (FR)**
• **LAGARDE, Thierry, L.**
**F-38100 Grenoble (FR)**
• **ARNAL, Yves, A.**
**F-38320 Poisat (FR)**
• **BURKE, Rudolf, R.**
**F-38000 Grenoble (FR)**
• **COCAGNE, Jacques, R.**
**F-38500 La Buisse (FR)**
• **DEVINE, Roderick, A.**
**F-38950 Saint-Martin-le-Vinoux (FR)**

(74) Mandataire: **Texier, Christian et al**
**Cabinet Régimbeau**
**20, rue de Chazelles**
**75847 Paris cedex 17 (FR)**

(56) Documents cités:
**EP-A- 0 583 736        US-A- 4 389 299**
**US-A- 5 354 381**

EP 0 819 314 B1

**Description**

La présente invention concerne le domaine technique du contrôle du bombardement d'un corps, au sens général, de nature et de forme quelconques, le bombardement étant effectué à l'aide de particules ioniques et électroniques dans le plasma.

L'objet de l'invention trouve une application particulièrement avantageuse pour la production de faisceaux intenses d'ions neutralisés, la pulvérisation ou l'érosion ionique, l'implantation ionique, le traitement, notamment, par dépôt, gravure, traitement chimique ou thermochimique de la surface d'un corps ou d'un substrat. Une application plus spécifique de l'implantation ionique peut aussi concerner les réactions nucléaires comme les réactions de fusion et la production de neutrons par bombardement de cibles deutériées ou tritiées par ions deutérium ou tritium.

Dans le domaine technique du traitement des matériaux par des plasmas froids, les paramètres pertinents de l'interaction plasma-surface sont le flux des radicaux neutres réactifs sur la surface, l'intensité et l'énergie de bombardement ionique, ainsi que la température de la surface. Si, pour une densité de plasma donnée, le flux de radicaux neutres réactifs peut être facilement réglé à partir de la pression partielle de gaz réactif, l'énergie du bombardement ionique est contrôlée par la polarisation négative de la surface par rapport au potentiel plasma.

Dans le cas d'un substrat conducteur, le substrat peut être polarisé à un potentiel $V_0$ par la simple application au substrat, d'une tension continue $V_0$ par rapport au potentiel plasma $V_p$ considéré comme origine des potentiels pour les particules chargées (ions et électrons) qui entrent dans la constitution du plasma. Si une tension continue positive par rapport à $V_p$ est appliquée au substrat, les ions positifs sont repoussés, tandis que les électrons du plasma sont accélérés vers la surface du substrat. Par contre, si une tension continue négative par rapport à $V_p$ est appliquée au substrat, les électrons sont repoussés en tout ou partie, selon la barrière énergétique $(V_p - V)$ imposée aux gaz d'électrons de température électronique $T_e$, tandis que les ions sont accélérés vers le substrat. L'énergie acquise par les ions qui frappent la surface du substrat est alors égale à

$$W = e(V_p - V) \qquad (1)$$

où $e = 1,6 \times 10^{-19}$ Coulomb correspond à la charge élémentaire.

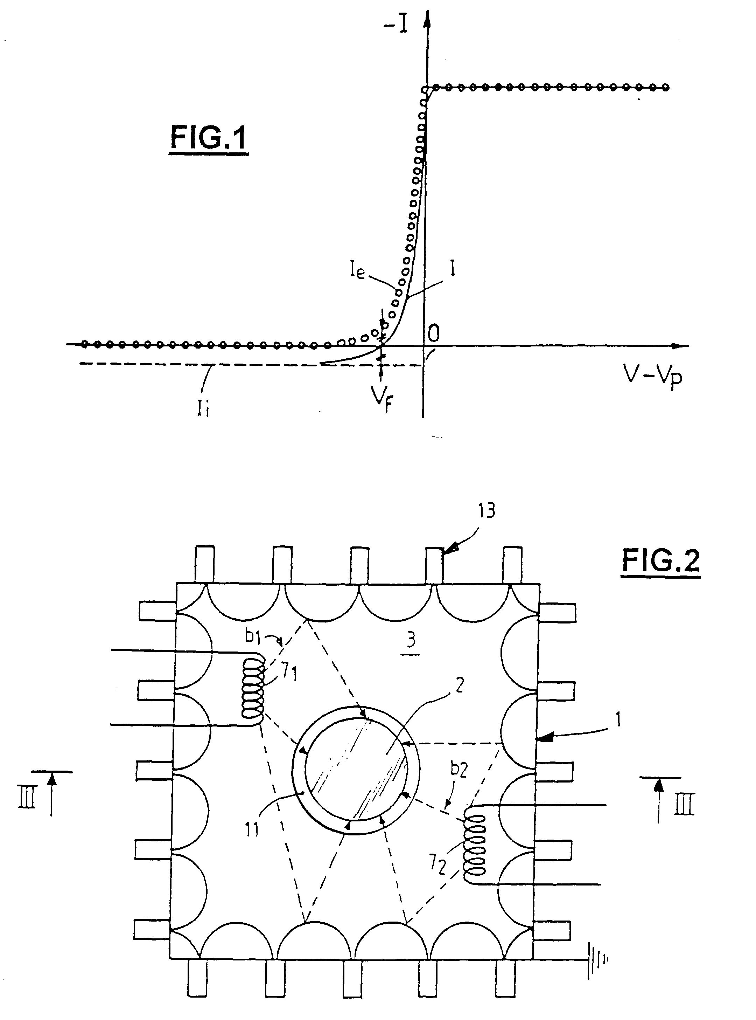

Dans le cas d'une surface plane, la caractéristique du courant I en fonction de la tension $V - V_p$, obtenue dans le cas d'un plasma isotrope et maxwellien, prend l'allure représentée sur la fig. 1. Le courant I correspond à la somme algébrique du courant électronique $I_e$ et du courant ionique $I_i$. De manière générale, l'intensité du courant de saturation électronique $I_e$, pour des valeurs de $V > V_p$ est telle que :

$$I_e = -e n_e S \left( \frac{kT_e}{2\pi m_e} \right)^{\frac{1}{2}} \qquad (2)$$

En raison de la différence entre la masse de l'électron me et la masse des ions $m_i$, l'intensité du courant de saturation électronique $I_e$ est très grande devant l'intensité du courant de saturation ionique $I_i$ de formule approchée :

$$I_i = e n_i S \left( \frac{kT_e}{m_i} \right)^{1/2} \exp\left( -\frac{1}{2} \right) \qquad (3)$$

Dans les expressions (2) et (3), $n_e$ est la densité électronique du plasma, ni est la densité ionique du plasma, S la surface de collection et k la constante de Boltzmann. La température électronique $T_e$ est généralement située entre 1 et quelques électrons-volts.

Dans le domaine du potentiel répulsif, à savoir $(V < V_p)$, seuls sont collectés les électrons dont la vitesse thermique est suffisante pour franchir la barrière de potentiel $(V_p - V)$. Dans le cas d'un plasma maxwellien de température électronique $T_e$, l'intensité du courant électronique $I_e$ collectée décroît donc exponentiellement en fonction de la différence de potentiel $(V_p - V)$, soit :

$$I_e = - e n_e S \left( \frac{kT_e}{2\pi m_e} \right)^{1/2} \exp \left[ \frac{e(V - V_p)}{kT_e} \right] \qquad (4)$$

Le potentiel flottant $V_f$, c'est-à-dire le potentiel pris par la surface du substrat non soumise à une polarisation externe, est obtenu lorsque les courants électronique $I_e$ et ionique $I_i$ collectés sont d'égale intensité, soit en régime permanent :

$$I_e + I_i = 0 \qquad (5)$$

Le potentiel flottant $V_f$, situé dans le domaine des valeurs $V < V_p$, et illustré sur la fig. 1, se déduit de l'égalité des équations (3) et (4) avec $n_e = n_i$, soit :

$$V_f - V_p = - \frac{kT_e}{2e} \left( 1 + \ln \frac{m_i}{2\pi m_e} \right) \qquad (6)$$

Il doit être considéré que les équations (2) à (6) données ci-dessus sont calculées dans l'hypothèse d'une surface plane du substrat et d'une distribution maxwellienne en énergie des électrons. Bien entendu, ces résultats sont modifiés lorsque ces deux hypothèses ne sont pas respectées, mais ils restent parfaitement valables qualitativement. En particulier, la valeur du courant de saturation dépend de la forme géométrique de la surface. Toutefois, la surface du substrat peut être assimilée à une surface plane, tant que le rayon de courbure de la surface reste grand devant la longueur de Debye électronique.

$$\lambda^2_{De} = \frac{\varepsilon_0 K T_e}{n_e e^2} \qquad (7)$$

C'est généralement le cas dans les plasmas considérés, où $\lambda_{De}$ est de l'ordre de la centaine de microns. Par ailleurs, les calculs précédents ont explicitement supposé que les plasmas considérés étaient exempts d'ions négatifs, ce qui n'est généralement pas le cas avec les plasmas réactifs le plus souvent utilisés dans les traitements de surface. La seule modification apportée par la présence d'ions négatifs est de réduire le courant d'électrons proportionnel au facteur $\beta = n_e / n_i$, où $n_e$ est la densité électronique du plasma et $n_i$ est la densité d'ions positifs, le courant d'ions négatifs pouvant être négligé devant le courant d'électrons. La présence des ions négatifs modifie, par conséquent, le potentiel flottant qui devient

$$V_f - V_p = - \frac{kT_e}{2e} \left( 1 + \ln \frac{m_i}{2\pi m_e} + 2 \ln \beta \right) \qquad (8)$$

Il apparaît ainsi une réduction significative de l'écart du potentiel flottant avec le potentiel plasma.

Dans la description qui précède, il a été supposé que la surface en contact avec le plasma n'apporte pas de perturbations importantes au plasma. Cette hypothèse est vérifiée lorsque le substrat présente de petites dimensions devant les dimensions caractéristiques du réacteur plasma. Dans le cas général, c'est-à-dire pour un substrat dont les dimensions caractéristiques représentent une fraction significative des dimensions caractéristiques du réacteur, le substrat peut apporter une perturbation importante au plasma.

Il a été ainsi démontré, notamment dans l'article J. PELLETIER et al, Rev. Sci. Instrum. 55, 1636 (1984) qu'il n'est pas possible de polariser une grande surface d'un substrat positivement par rapport au potentiel plasma. En effet, sauf dans des situations exceptionnelles, le potentiel plasma $V_p$ reste toujours plus positif que le potentiel de la surface du substrat. Par conséquent, seul le domaine des potentiels V inférieurs au potentiel plasma $V_p$ est accessible pour la polarisation des surfaces de grandes dimensions de l'ordre d'une fraction des dimensions caractéristiques du plasma.

Si l'application d'une tension continue est possible dans le cas d'un substrat conducteur ou d'une surface conductrice, la polarisation d'un substrat isolant ou d'une surface isolante, par rapport au potentiel plasma, n'est plus possible. Une possibilité utilisée couramment en microélectronique consiste à polariser la surface en contact avec le plasma par effet capacitif. A cet effet, une tension périodique est appliquée au substrat à travers une capacité de faible impédance. La tension de polarisation moyenne $V_0$ s'établit alors à une valeur telle que la moyenne du courant électronique et ionique collectée sur l'ensemble d'une période soit nulle.

Il apparaît donc que la polarisation par rapport au potentiel plasma de substrats de grandes dimensions peut s'effectuer, soit par l'application d'une tension continue négative à un substrat conducteur, soit par l'application, à travers une capacité de faible impédance, d'une tension périodique à un substrat conducteur ou isolant. Il apparaît, toutefois, que la polarisation capacitive présente un certain nombre d'inconvénients.

Le premier concerne la forme des substrats, car il est évident que la polarisation des substrats par effet capacitif est facilement applicable uniquement aux substrats plans. Une telle méthode de polarisation exclut le traitement de pièces présentant des formes complexes, de nature par exemple moulée ou forgée, de structures aléatoires, telles que les structures composites ou les fibres.

Un autre inconvénient de cette technique est relatif à l'épaisseur des substrats, car l'efficacité de la polarisation par effet capacitif dépend de la capacité de couplage avec la surface en contact avec le plasma. La capacité de couplage à travers le substrat doit être aussi élevée que possible ou d'impédance aussi faible que possible, s'il veut être obtenue une chute de tension à travers cette capacité qui soit faible devant la tension périodique appliquée au porte-substrat. L'efficacité de la polarisation par effet capacitif de substrats isolants, d'épaisseur croissante décroît corrélativement à la capacité de couplage introduite par le substrat isolant. La polarisation par effet capacitif ne peut donc pas être envisagée pour des pièces isolantes épaisses.

Un autre inconvénient concerne tous les types de substrats, y compris les substrats plans et minces, pour lesquels la polarisation par effet capacitif est efficace, comme les plaquettes de silicium utilisées pour la fabrication des circuits intégrés. Dans ce dernier cas, les substrats, à certaines étapes de fabrication, comportent des empilements localisés de couches isolantes, semi-conductrices et conductrices. Or, durant un traitement plasma avec polarisation par effet capacitif, le substrat va accumuler sur sa surface, à chaque alternance, des charges électriques positives, puis négatives, qui peuvent induire des phénomènes électriques préjudiciables dans les couches sous-jacentes, tels qu'un claquage des diélectriques, une électromigration ou des défauts induits.

La technique de polarisation par effet capacitif présente un autre inconvénient majeur lié au fait que dans la plupart des procédés, le porte-substrat, à travers lequel la polarisation capacitive est appliquée, doit également assurer le maintien de la température du substrat pendant le traitement. Cette double fonction du porte-substrat, maintien et contrôle de la température et polarisation, entraîne une grande complexité des dispositifs connus.

On connaît déjà par US 4,389,299 une technique de bombardement d'un corps selon lequel un générateur produit un plasma confiné par une structure magnétique et un filament produit un flux d'électrons piégés par le champ magnétique où ils produisent une ionisation accrue du plasma, les atomes d'une cible étant pulvérisés par le bombardement ionique résultant de l'accélération des ions positifs sur ladite cible, laquelle est polarisée négativement par les sources continues ou radiofréquences.

L'invention propose quant à elle un procédé et un dispositif permettant d'une manière générale, de maîtriser de façon séparée ou conjuguée, l'énergie des ions et des électrons bombardant un corps de forme et de nature quelconques en contact avec un plasma.

Le procédé selon l'invention est défini par la revendication 1. Le dispositif selon l'invention est défini par la revendication 6. Des modes particuliers de réalisation de cette invention sont décrits dans les revendications dépendantes.

Avantageusement, le corps est isolé électriquement et la polarisation de sa surface est contrôlée par au moins un flux d'électrons énergétiques bombardant sa surface. Par exemple, le corps peut être isolé dans le plasma (gouttelettes, particules de poudre, etc). Il peut également être en un matériau de nature isolante. Des moyens pour isoler électriquement le corps peuvent être prévus.

En variante, la surface du corps est en outre soumise à l'application d'une tension de polarisation.

Avantageusement encore, le procédé consiste à créer, de manière indépendante aux moyens de production du plasma, deux flux d'électrons énergétiques, présentant chacun une intensité et une énergie déterminées pour permettre de contrôler à la fois l'énergie des ions et des électrons bombardant le corps.

Selon une variante de réalisation, le procédé selon l'invention consiste à créer, de manière indépendante aux moyens de production du plasma, une série de $n$ faisceaux d'électrons énergétiques (avec $n > 2$), présentant chacun une intensité et une énergie déterminées pour assurer le contrôle à la fois de l'énergie des ions et la fonction de distribution en énergie des électrons bombardant le corps.

Conformément à l'invention, la production du plasma est dissociée de la polarisation du corps et du contrôle de l'énergie de bombardement des ions et des électrons, de sorte qu'il peut être obtenu un contrôle indépendant des différents paramètres de l'interaction plasma-surface. Le procédé permet ainsi de polariser la surface d'un corps de toutes formes et de toutes natures, auquel aucune tension continue ou périodique n'est appliquée. Il permet aussi de contrôler les énergies et les flux d'électrons à la surface d'un corps polarisée par application d'une tension de polarisation.

Diverses autres caractéristiques ressortent de la description faite ci-dessous en référence aux dessins annexés qui montrent, à titre d'exemples non limitatifs, des formes de réalisation et de mise en oeuvre de l'objet de l'invention.

La fig. 1 illustre la caractéristique courant-tension obtenue sur un substrat plan, dans le cas d'un plasma isotrope ou maxwellien connu de l'art antérieur.

La fig. 2 est une vue schématique d'un exemple d'une machine de traitement mettant en oeuvre le procédé selon l'invention.

La fig. 3 est une vue en coupe schématique prise sensiblement selon les lignes III-III de la fig. 2.

Les fig. 4, 5 et 6 représentent la caractéristique courant-tension obtenue selon trois variantes de réalisation de l'objet de l'invention.

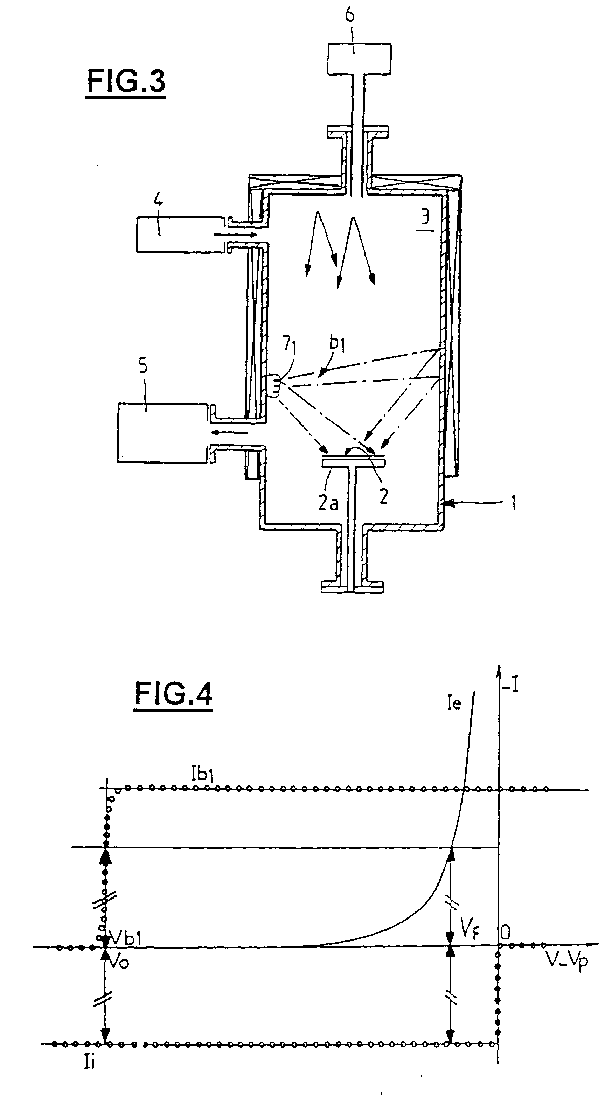

Tel que cela ressort plus précisément des fig. 2 et 3, la machine 1 est adaptée pour assurer le contrôle du bombardement d'un corps 2 de toute nature et de forme diverses, tel qu'un substrat, placé sur un porte-substrat 2a auquel on peut éventuellement appliquer une tension de polarisation. La machine de contrôle 1, qui peut, dans l'exemple illustré, assurer l'exécution d'opérations de traitement, telles que de gravures ou de dépôts, comporte une enceinte étanche 3 à l'intérieur de laquelle est placé le porte-substrat 2a isolé électriquement de l'enceinte qui est portée à un potentiel fixe, tel que la masse par exemple. L'enceinte 3 est équipée d'un dispositif 4 d'introduction de gaz et d'un dispositif 5 de pompage de gaz permettant de maintenir la pression de gaz à ioniser à une valeur souhaitée, qui peut être, par exemple, de l'ordre de $10^{-3}$ à quelques Pascal. La machine 1 comporte également des moyens 6 de production d'un plasma, à partir de l'excitation du milieu gazeux. Les moyens 6 sont de tous types connus de l'homme du métier pour produire un plasma. Par exemple, il peut être prévu d'utiliser une source de plasma micro-onde localisée, une source de plasma excité à la résonance cyclotronique électronique, ou une source de plasma répartie à la surface de la structure magnétique multipolaire.

Conformément à l'invention, la machine 1 comporte au moins une source de production d'un flux d'électrons énergétiques. Dans l'exemple illustré à la fig. 3, la machine comporte une source $7_1$ de production d'un flux d'électrons énergétiques $b_1$ présentant une intensité $I_{b1}$, un potentiel $V_{b1}$ et une énergie $W_{b1} = e (V_p - V_{b1})$. Selon l'invention, le flux d'électrons énergétiques $b_1$ est créé de manière totalement indépendante des moyens 6 de production du plasma. La production d'électrons énergétiques peut s'effectuer à partir d'une électrode émissive d'électrons en la polarisant négativement par rapport au potentiel plasma. L'émission des électrons énergétiques peut aussi se faire à partir de cathodes chaudes, de filaments par exemple. Une autre possibilité est d'utiliser l'émission d'électrons par effet photo-électrique par une cathode, soit à partir des photons émis par le plasma, soit à partir d'une source de photons extérieure au plasma. Les techniques de production d'électrons énergétiques décrites ci-dessus ne sont pas limitatives et différentes autres méthodes de production d'électrons énergétiques peuvent être envisagées, telles que canon à électrons, plasma auxiliaire, effet de champ, etc.

Il doit être considéré que la source $7_1$ est adaptée pour créer un flux d'électrons énergétiques, c'est-à-dire des électrons accélérés à une énergie donnée et dont la température est généralement faible devant l'énergie de ces électrons. Si le plasma est peu collisionnel, c'est-à-dire si le libre parcours moyen des électrons énergétiques est supérieur aux dimensions du plasma, les électrons énergétiques injectés dans le plasma, qui restent énergétiques, et les électrons du plasma peuvent être considérés comme deux populations d'électrons indépendantes. Les électrons énergétiques ainsi injectés dans le plasma viennent se superposer au flux d'ions et d'électrons du plasma collectés par la surface du substrat. Les électrons énergétiques, après avoir traversé le plasma, viennent frapper la surface du substrat et, si celle-ci est électriquement isolée, la polarisent.

Il doit être compris que la tension de polarisation $V_0$ négative ($V_0 < V_p$) prise par la surface du substrat 2, est alors obtenue en régime permanent, lorsque le courant total collecté par la surface isolée est globalement nul, soit

$$I_{b1} [V_0 - V_p] + I_e [V_0 - V_p] + I_i [V_0 - V_p] = 0 \qquad (9)$$

avec :

- $I_{b1}$ : l'intensité du courant d'électrons énergétiques collectés par la surface du substrat, en fonction de l'écart $V_0 - V_p$, le potentiel plasma $V_p$ étant pris comme origine des potentiels dans le plasma,
- $I_e$ : l'intensité du courant d'électrons du plasma collectés par la surface du substrat, en fonction de l'écart $V_0 - V_p$,
- et $I_i$ : l'intensité du courant ionique positif du plasma collecté par la surface du substrat, en fonction de l'écart $V_0 - V_p$.

Cette expression très générale peut être simplifiée pour différents cas particuliers et diverses hypothèses. Ainsi, si la surface du substrat 2 peut être assimilée à une surface plane, le courant de saturation ionique $I_i$ est constant [cf. équation (3)].

De même, si e $(V_0 - V_p) \gg kT_e$, le courant électronique $I_e$ dû aux électrons du plasma peut être négligé devant le courant ionique $I_i$ et le courant $I_{b1}$ d'électrons énergétiques. De même, il peut être considéré des populations d'électrons énergétiques quasi monocinétiques d'énergie e $(V_p - V_{b1})$.

Le mode de polarisation du substrat, à l'aide d'électrons énergétiques additionnels, offre diverses possibilités de contrôle des flux de bombardement du substrat, en particulier sur un substrat électriquement isolé.

La fig. 4 illustre un premier cas de figure dans lequel l'intensité du courant d'électrons énergétiques $I_{b1}$ est supérieur à l'intensité du courant de saturation ionique $I_i$ pour les potentiels $V > V_{b1}$. Dans cette hypothèse et compte tenu des simplifications précédentes, l'équation (9) est satisfaite pour $V_0 \approx V_{b1}$. L'énergie de bombardement électronique sur la surface du substrat 2 électriquement isolé est alors quasi nulle. La tension de polarisation $V_0$ s'établit à une valeur proche de $V_{b1}$. Les ions du plasma sont alors accélérés dans la gaine électrostatique 11 entourant le substrat 2 et bombardant le substrat avec une énergie e $(V_p - V_{b1})$.

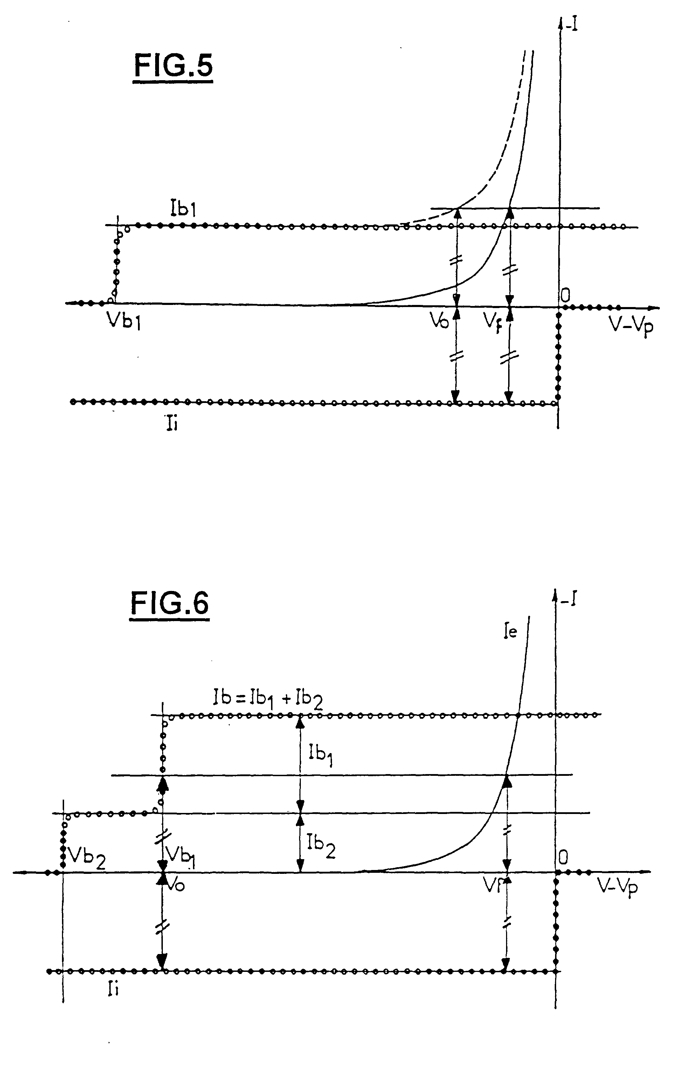

La fig. 5 illustre un autre exemple dans lequel l'intensité $I_{b1}$ du courant d'électrons énergétiques reste toujours inférieure à l'intensité du courant de saturation ionique $I_i$. Dans ce cas, le potentiel de polarisation $V_0$ s'établit à une valeur légèrement négative par rapport au potentiel flottant $V_f$ qui apparaît dans un plasma exempt d'électrons énergétiques, soit

$$V_0 - V_f = - \frac{kT_e}{e} \ln \left( \frac{I_i}{I_i + I_{b1}} \right) \qquad (10)$$

L'énergie de bombardement des électrons rapides sur la surface du substrat vaut alors e $(V_0 - V_{b1})$. L'énergie de bombardement ionique e $(V_p - V_0)$ reste faible.

D'après ce qui précède, en régime permanent, le potentiel de la surface du substrat 2 électriquement isolé s'ajuste de façon à assurer l'égalité des courants d'électrons et d'ions collectés. Si le courant des électrons énergétiques reste inférieur au courant de saturation ionique, le potentiel de la surface ne s'écarte que faiblement du potentiel flottant $V_f$ qui s'établit en l'absence d'électrons énergétiques. La surface est alors soumise essentiellement au bombardement des électrons énergétiques, dans la mesure où l'énergie du bombardement par les ions et les électrons du plasma reste faible. Au contraire, si l'intensité du courant d'électrons énergétiques injectés sur la surface du substrat est supérieure à l'intensité du courant de saturation ionique, l'énergie de bombardement ionique devient égale à l'énergie des électrons énergétiques, tandis que l'énergie de bombardement électronique par les seuls électrons énergétiques devient nulle ou très faible. L'injection d'un flux d'électrons énergétiques permet de contrôler l'énergie de l'une des espèces bombardant le substrat.

L'objet de l'invention offre également une autre possibilité de polarisation dans laquelle au moins deux flux d'électrons énergétiques $b_1$, $b_2$ sont introduits dans l'enceinte. Dans l'exemple illustré plus particulièrement à la fig. 2, l'enceinte 1 est équipée de deux sources $7_1$, $7_2$ indépendantes, de production chacune d'un flux d'électrons énergétiques $b_1$, $b_2$, ces flux étant créés de manière totalement indépendante des moyens 6 de production du plasma. Les électrons énergétiques comportent ainsi deux populations distinctes d'électrons d'énergie distincte, généralement grande devant l'énergie thermique des électrons du plasma. Il est ainsi collecté, sur le substrat, un courant d'électrons injectés avec l'énergie e $(V_p - V_{b1})$ et d'intensité $I_{b1}$ et un courant d'électrons injectés avec l'énergie e $(V_p - V_{b2})$ et d'intensité $I_{b2}$. Tel que cela apparaît plus précisément à la fig. 6, l'intensité $I_{b2}$ est choisie de manière à être inférieure à l'intensité du courant de saturation ionique $I_i$, tandis que la somme des intensités $I_{b1}$ et $I_{b2}$ est choisie supérieure à l'intensité du courant de saturation ionique $I_i$. Dans ce cas et compte tenu des hypothèses simplificatrices précédentes, l'équation (9) est satisfaite pour $V_0 = V_{b1}$. L'énergie de bombardement de la surface du substrat 2 électriquement isolé, par les électrons injectés avec l'énergie e $(V_p - V_{b1})$ est donc quasi nulle, tandis que l'énergie de bombardement de la surface du substrat par les électrons injectés avec l'énergie e $(V_p - V_{b2})$ est égale à e $(V_{b1} - V_{b2})$. Il est donc possible en utilisant au moins deux sources distinctes d'électrons énergétiques de contrôler à la fois l'énergie du bombardement ionique et l'énergie du bombardement électronique sur la surface à traiter. Bien entendu, il pourrait être envisagé de mettre en oeuvre une série de $\underline{n}$ sources $7_1$, $7_2$, ..., $7_n$, avec $\underline{n} > 2$, de production de flux d'électrons énergétiques $(b_1$, $b_2$, ..., $b_n)$, de manière à contrôler à la fois l'énergie des ions et la fonction de distribution en énergie des électrons bombardant la surface d'un substrat.

D'une manière avantageuse, les sources de production sont équipées de moyens adaptés pour permettre de régler l'intensité et l'énergie des flux d'électrons énergétiques émis.

Selon une autre caractéristique de l'invention, les flux d'électrons énergétiques sont confinés par une structure magnétique multipolaire 13, afin de favoriser le bombardement du substrat par les électrons énergétiques, au détriment de l'enceinte 1. Tel que cela apparaît plus précisément à la fig. 2, les électrons énergétiques sont réfléchis par la structure de confinement 13 pour venir bombarder le substrat 2. Il est avantageux de produire alors le plasma par des moyens conventionnels, par exemple, en utilisant une source de plasma localisée ou, de préférence, une source de plasma utilisant, pour l'excitation du plasma, la structure de confinement multipolaire elle-même. Comme dans les structures magnétiques de type magnétron utilisées pour les dépôts par pulvérisation, le plasma peut être produit par application de tension continue, basse fréquence ou radiofréquence, entre la structure magnétique multipolaire et une autre électrode (paroi ou conducteur). Le plasma peut aussi être excité par résonance cyclotronique électronique répartie par application d'un champ électrique micro-onde, pourvu que la structure magnétique multipolaire puisse fournir les conditions de résonance cyclotronique électronique. Selon ces exemples de réalisation, la structure de confinement 13 peut être réalisée par une série d'aimants permanents présentant, successivement au plasma, des polarités alternées. Bien entendu, la structure de confinement peut être fermée ou non en fonction, notamment, de la forme du substrat à traiter.

Le procédé selon l'invention permet de remédier aux problèmes de polarisation des techniques antérieures, mais assure, également, un contrôle de l'énergie de l'une au moins des espèces chargées bombardant le substrat, à savoir les électrons et les ions. Il s'ensuit une possibilité de contrôle des mécanismes réactionnels de surface engendrés par les ions positifs (effets mécaniques et électrochimiques) et par les électrons (effets électrochimiques), aussi bien sur des substrats isolés électriquement que sur des substrats polarisés par application d'une tension quelconque. Un autre avantage de l'invention concerne la possibilité de polariser la surface d'un substrat isolant d'épaisseur quelconque, puisque la polarisation n'est pas obtenue par effet capacitif. Un autre avantage concerne la polarisation de substrats isolants de forme quelconque, pour lesquels la polarisation par effet capacitif est difficile, voir impossible. Un avantage supplémentaire de ce procédé de polarisation est de pouvoir réaliser une polarisation dite par neutralisation fine, ne provoquant pas de variations temporelles et spatiales des charges électriques sur la surface du substrat. Un dernier avantage apporté par l'invention est la simplification du porte-substrat dans le cas d'un traitement de surface, puisqu'il n'y a plus que deux fonctions à assurer, à savoir le maintien du substrat (clampage mécanique, électrostatique) et le contrôle de la température du substrat (chauffage ou refroidissement).

Parmi les valeurs numériques fondamentales intéressant les différents aspects de l'invention, les plus importantes concernent les différents libres parcours moyens des électrons dans le plasma. A titre d'exemple, le plasma d'argon à 1 mtorr est pris comme plasma de référence. Dans un tel plasma, si l'on considère les collisions élastiques sur les neutres, le libre parcours moyen d'un électron d'énergie (50 eV) est de 0,30 m. Pour les collisions ionisantes, le libre parcours moyen s'élève à 1,15 m. L'examen de ces deux longueurs montre que dans un réacteur de quelques litres de volume, un électron énergétique (50 eV) a peu de chances de produire des quantités significatives de plasma avant d'être collecté par le substrat ou une paroi de l'enceinte. En l'absence de substrat et en présence de confinement magnétique multipolaire, les électrons énergétiques sont réfléchis dans les gradients de champ magnétique à la périphérie de l'enceinte et peuvent donc ioniser plus efficacement le plasma par un facteur pouvant aller de 10 à 100. Toutefois, en présence de substrat, les électrons énergétiques injectés sont collectés par le substrat et ne peuvent à nouveau produire que des densités négligeables de plasma. Ceci montre bien que le système de polarisation, objet de l'invention, requiert effectivement une excitation de plasma indépendante de celle obtenue par les électrons présents dans le plasma, en particulier s'il est souhaité une indépendance aussi grande que possible entre la production de plasma et la polarisation du substrat dans ce plasma.

Le domaine d'énergie des faisceaux d'électrons injectés peut aller de quelques volts jusqu'à des valeurs très grandes en fonction des applications envisagées. Ainsi, la pulvérisation et l'érosion ionique requièrent des énergies pouvant dépasser largement le kilovolt (1 kV), et l'implantation ionique requiert des énergies pouvant dépasser largement la dizaine de kilovolts. Dans ce cas, et pour éviter des claquages et aussi le chauffage non intentionnel des substrats, il peut être envisagé non plus de travailler en régime continu, mais en régime modulé, haché ou pulsé. De même, cette variation peut être effectuée aussi sur le courant du faisceau d'électrons injectés.

Dans la description qui précède, le procédé selon l'invention concerne le contrôle du bombardement d'un corps constitué, plus précisément, par un substrat. Il doit être considéré que l'objet de l'invention s'applique à tout corps, au sens général, à caractère isolant ou conducteur. Ainsi, l'objet de l'invention permet de polariser et de contrôler le bombardement ionique et électronique d'un corps, tel que par exemple, des matériaux composites ou encore des poudres, produites ou injectées au sein du plasma, en suspension ou en transit dans la phase gazeuse du plasma. Les poudres peuvent être des particules solides, mais aussi des particules liquides (brouillard ou gouttelettes) à faible pression de vapeur saturante.

**Revendications**

1. Procédé pour contrôler le bombardement d'un substrat (2) plongé dans une enceinte étanche (3), dans laquelle des moyens (6) produisent un plasma confiné par une structure magnétique multipolaire (13),
   ledit procédé étant caractérisé en ce qu'il consiste à créer, de manière indépendante aux moyens (6) de production du plasma, au moins un flux d'électrons énergétiques ($b_1$, $b_2$, ..., $b_n$) confinés par la structure magnétique multipolaire (13) et bombardant le substrat à traiter (2), et présentant une intensité ($I_{b1}$, $I_{b2}$, ..., $I_{bn}$) et une énergie déterminées pour contrôler la polarisation de la surface du substrat à traiter par au moins un flux d'électrons énergétiques bombardant la surface, assurant ainsi le contrôle de l'énergie de l'une au moins des espèces chargées, ions ou électrons, présents dans la structure magnétique multipolaire et bombardant le substrat à traiter (2).

2. Procédé selon la revendication 1, caractérisé en ce que le substrat (2) est isolé électriquement.

3. Procédé selon la revendication 1, caractérisé en ce que la surface du substrat (2) est en outre soumise à l'application d'une tension de polarisation.

4. Procédé selon l'une des revendications précédentes, caractérisé en ce qu'il consiste à créer, de manière indépendante aux moyens de production du plasma (6), deux flux d'électrons énergétiques ($b_1$, $b_2$), présentant chacun une intensité ($I_{b1}$, $I_{b2}$) et une énergie déterminées pour permettre de contrôler à la fois l'énergie des ions et des électrons bombardant la surface du substrat.

5. Procédé selon l'une des revendications précédentes, caractérisé en ce qu'il consiste à créer, de manière indépendante aux moyens de production du plasma (6), une série de $\underline{n}$ faisceaux d'électrons énergétiques ($b_1$, $b_2$, ..., $b_n$), avec $\underline{n} > 2$, présentant chacun une intensité et une énergie déterminées pour assurer le contrôle à la fois de l'énergie des ions et la fonction de distribution en énergie des électrons bombardant le substrat.

6. Dispositif pour contrôler le bombardement d'un substrat soumis à un plasma, le dispositif comportant :

   - une enceinte étanche (3) raccordée à un circuit de pompage (5) et à un circuit d'apport (4) d'un milieu gazeux pour maintenir une pression déterminée dans l'enceinte,
   - des moyens (6) pour assurer la production du plasma à partir du milieu gazeux,
   - et une structure magnétique multipolaire (13) de confinement du plasma,

   caractérisé en ce qu'il comporte au moins une source ($7_1$, $7_2$, ..., $7_n$) de production d'un flux d'électrons énergétiques, indépendante des moyens de production du plasma (6), confinés par la structure multipolaire (13) pour bombarder le substrat et dont l'intensité et l'énergie sont déterminées pour contrôler la polarisation de la surface du substrat par au moins un flux d'électrons énergétiques bombardant la surface, assurant ainsi le contrôle de l'énergie de l'une au moins des espèces chargées, ions ou électrons, présents dans la structure magnétique multipolaire et bombardant le substrat (2).

7. Dispositif selon la revendication 6, caractérisé en ce que le substrat (2) est isolé dans le plasma.

8. Dispositif selon la revendication 6, caractérisé en ce que le substrat (2) est en un matériau de nature isolante, la polarisation de sa surface étant contrôlée par au moins un flux d'électrons énergétiques ($b_1$, $b_2$, ..., $b_n$) bombardant sa surface.

9. Dispositif selon la revendication 6, caractérisé en ce qu'il comporte des moyens pour isoler électriquement ledit substrat (2), la polarisation de sa surface étant contrôlée par au moins un flux d'électrons énergétiques ($b_1$, $b_2$, ..., $b_n$) bombardant sa surface.

10. Dispositif selon la revendication 6, caractérisé en ce qu'il comporte des moyens pour appliquer une tension de polarisation à la surface du substrat (2).

**11.** Dispositif selon l'une des revendications 6 à 10, caractérisé en ce qu'il comporte deux sources ($7_1$, $7_2$) de production d'un flux d'électrons énergétiques ($b_1$, $b_2$), indépendantes des moyens de production du plasma (6), et dont l'intensité ($I_{b1}$, $I_{b2}$) et l'énergie des électrons énergétiques sont déterminées pour permettre de régler à la fois l'énergie des ions et des électrons bombardant le substrat.

**12.** Dispositif selon l'une des revendications 6 à 10, caractérisé en ce qu'il comporte une série de $\underline{n}$ sources ($7_1$, $7_2$, ..., $7_n$) de production d'un flux d'électrons énergétiques, avec $\underline{n}$ > 2, indépendantes des moyens de production du plasma, et dont l'intensité et l'énergie des électrons énergétiques sont déterminées pour permettre de régler à la fois l'énergie des ions et la fonction de distribution en énergie des électrons bombardant le substrat.

**13.** Dispositif selon l'une des revendications 6 à 12, caractérisé en ce que chaque source de production d'un flux d'électrons énergétiques ($7_1$, $7_2$, ..., $7_n$) présente des moyens pour régler l'intensité et l'énergie du flux d'électrons.

**14.** Dispositif selon l'une des revendications 6 à 13, caractérisé en ce que chaque source ($7_1$, $7_2$, ..., $7_n$) produise de façon continue, pulsée, hachée ou modulée, un flux d'électrons énergétiques.

**15.** Dispositif selon l'une des revendications 6 à 14, caractérisé en ce que les moyens de production du plasma (6) sont constitués, au moins en partie, par la structure magnétique multipolaire de confinement (13).

**16.** Dispositif selon la revendication 15, caractérisé en ce que la structure magnétique multipolaire (13) est excitée par une tension continue, basse fréquence, radiofréquence ou micro-onde.

**17.** Dispositif selon la revendication 15, caractérisé en ce que les moyens de production du plasma (6) s'effectuent par couplage en champ magnétique à la résonance cyclotronique électronique.


**Patentansprüche**

**1.** Verfahren zum Steuern des Beschusses eines Substrates (2), das in einen dichten Behälter (3) getaucht ist, in dem Mittel (6) ein durch eine magnetische Multipolkonfiguration (13) begrenztes Plasma erzeugen, wobei das Verfahren dadurch gekennzeichnet ist, daß es folgende Schritte umfaßt: Erzeugen, unabhängig von den Plasmaerzeugungsmitteln (6), wenigstens eines Flusses energiereicher Elektronen ($b_1$,$b_2$, ...,$b_n$), die von der magnetischen Multipolkonfiguration (13) begrenzt sind und das zu bearbeitende Substrat (2) beschießen, und eine Intensität ($I_{b1}$, $I_{b2}$, ..., $I_{bn}$) und eine Energie aufweisen, die so bestimmt sind, daß die Polarisation der Oberfläche des zu bearbeitenden Substrates mit wenigstens einem die Oberfläche beschießenden Fluß energiereicher Elektronen gesteuert wird, die auf diese Weise die Steuerung der Energie von wenigstens einer der geladenen Arten, Ionen oder Elektronen, sicherstellen, die in der magnetischen Multipolkonfiguration vorliegen und das zu bearbeitende Substrat (2) beschießen.

**2.** Verfahren nach Anspruch 1, dadurch gekennzeichnet, daß das Substrat (2) elektrisch isoliert ist.

**3.** Verfahren nach Anspruch 1, dadurch gekennzeichnet, daß an die Oberfläche des Substrats (2) außerdem eine Polarisationsspannung angelegt wird.

**4.** Verfahren nach einem der vorhergehenden Ansprüche, dadurch gekennzeichnet, daß es folgende Schritte umfaßt: Erzeugen, unabhängig von den Plasmaerzeugungsmitteln (6), von zwei Flüssen energiereicher Elektroden ($b_1$,$b_2$), die jeweils eine Intensität ($I_{b1}$, $I_{b2}$) und eine Energie aufweisen, die so bestimmt sind, daß sie gleichzeitig die Steuerung der Energie der Ionen und der Elektronen ermöglichen, welche die Oberfläche des Substrats beschießen.

**5.** Verfahren nach einem der vorhergehenden Ansprüche, dadurch gekennzeichnet, daß es die folgenden Schritte umfaßt: Erzeugen, unabhängig von den Plasmaerzeugungsmitteln (6), einer Reihe von $\underline{n}$ Strahlen energiereicher Elektronen ($b_1$, $b_2$,...,$b_n$), wobei $\underline{n}$>2, die jeweils eine Intensität und eine Energie aufweisen, die so bestimmt sind, daß sie die gleichzeitige Steuerung der Energie der Ionen und der Energieverteilungsfunktion der Elektronen sicherstellen, welche das Substrat beschießen.

**6.** Vorrichtung zum Steuern des Beschusses eines einem Plasma ausgesetzten Substrates, wobei die Vorrichtung folgendes umfaßt:

- einen dichten Behälter (3), der an eine Pumpeinrichtung (5) und an eine Einrichtung (4) zum Zuführen eines gasförmigen Milieus angeschlossen ist, um im Behälter einen vorbestimmten Druck aufrechtzuerhalten,
- Mittel (6) zum Sicherstellen der Erzeugung des Plasmas ausgehend von dem gasförmigen Milieu,
- und eine magnetische Multipolkonfiguration (13) für die Begrenzung des Plasmas,

dadurch gekennzeichnet, daß sie wenigstens eine Quelle ($7_1$, $7_2$, ..., $7_n$) zum Erzeugen eines Flusses energiereicher Elektronen, unabhängig von den Plasmaerzeugungsmitteln (6), aufweist, welche von der magnetischen Multipolkonfiguration (13) begrenzt sind, um das Substrat zu beschießen, und deren Intensität und Energie so bestimmt sind, daß die Polarisation der Oberfläche des Substrats mittels wenigstens eines die Oberfläche beschießenden Flusses energiereicher Elektronen gesteuert wird, die auf diese Weise die Steuerung der Energie von wenigstens einer der geladenen Arten, Ionen oder Elektronen, sicherstellen, die in der magnetischen Multipolkonfiguration vorliegen und das Substrat (2) beschießen.

7. Vorrichtung nach Anspruch 6, dadurch gekennzeichnet, daß das Substrat (2) in dem Plasma isoliert ist.

8. Vorrichtung nach Anspruch 6, dadurch gekennzeichnet, daß das Substrat (2) aus einem Material isolierender Art ist, und die Polarisation seiner Oberfläche durch wenigstens einen seine Oberfläche beschießenden Fluß energiereicher Elektronen ($b_1$, $b_2$, ..., $b_n$) gesteuert wird.

9. Vorrichtung nach Anspruch 6, dadurch gekennzeichnet, daß sie Mittel zum elektrischen Isolieren des Substrates (2) umfaßt, wobei die Polarisation von dessen Oberfläche durch wenigstens einen dessen Oberfläche beschießenden Fluß energiereicher Elektronen ($b_1$, $b_2$, ..., $b_n$) gesteuert wird.

10. Vorrichtung nach Anspruch 6, dadurch gekennzeichnet, daß sie Mittel zum Anlegen einer Polarisationsspannung an die Oberfläche des Substrats (2) umfaßt.

11. Vorrichtung nach einem der Ansprüche 6 bis 10, dadurch gekennzeichnet, daß sie zwei Quellen ($7_1$, $7_2$) zum Erzeugen eines Flusses energiereicher Elektronen ($b_1$, $b_2$) umfaßt, unabhängig von den Plasmaerzeugungsmitteln (6), bei denen die Intensität ($I_{b1}$, $I_{b2}$) und die Energie der energiereichen Elektronen so bestimmt sind, daß die gleichzeitige Einstellung der Energie von den Ionen und den Elektronen ermöglicht wird, welche das Substrat beschießen.

12. Vorrichtung nach einem der Ansprüche 6 bis 10, dadurch gekennzeichnet, daß sie eine Reihe von $\underline{n}$ Quellen ($7_1$, $7_2$, ..., $7_n$) zum Erzeugen eines Flusses energiereicher Elektronen umfaßt, mit $\underline{n}>2$, unabhängig von den Plasmaerzeugungsmitteln, bei denen die Intensität und die Energie der energiereichen Elektronen so bestimmt sind, daß die gleichzeitige Einstellung der Energie der Ionen und der Energieverteilungsfunktion der Elektronen ermöglicht wird, welche das Substrat beschießen.

13. Vorrichtung nach einem der Ansprüche 6 bis 12, dadurch gekennzeichnet, daß jede Quelle zum Erzeugen eines Flusses energiereicher Elektronen ($7_1$, $7_2$, ..., $7_n$) Mittel zum Einstellen des Intensität und der Energie des Elektronenflusses aufweist.

14. Vorrichtung nach einem der Ansprüche 6 bis 13, dadurch gekennzeichnet, daß jede Quelle ($7_1$, $7_2$, ..., $7_n$) einen kontinuierlichen, gepulsten, zerhackten oder modulierten Fluß energiereicher Elektronen erzeugt.

15. Vorrichtung nach einem der Ansprüche 6 bis 14, dadurch gekennzeichnet, daß die Plasmaerzeugungsmittel (6) wenigstens teilweise von der magnetischen Multipolkonfiguration (13) gebildet werden.

16. Vorrichtung nach Anspruch 15, dadurch gekennzeichnet, daß die magnetische Multipolkonfiguration (13) durch eine Gleichspannung, eine niederfrequente Spannung, eine hochfrequente Spannung oder eine Mikrowellenspannung angeregt wird.

17. Vorrichtung nach Anspruch 15, dadurch gekennzeichnet, daß die Plasmaerzeugungsmittel (6) durch eine Magnetfeldkopplung an die Elektron-Zyklotronresonanz bewirkt werden.

**Claims**

1.  A method of controlling bombardment of a substrate (2) immersed in a sealed enclosure (3) in which means (6) produce a plasma that is confined by a multipolar magnetic structure (13),

    said method being characterized in that it consists in creating, in a manner that is independent of the plasma-producing means (6), at least one flux of high-energy electrons ($b_1$, $b_2$, ..., $b_n$) confined by the multipolar magnetic structure (13) and bombarding the substrate (2) that is to be treated, and presenting a current ($I_{b1}$, $I_{b2}$, ..., $I_{bn}$) and an energy that are determined to control the bias of the surface of the substrate to be treated, by at least one flux of high-energy electrons bombarding the surface, thus controlling the energy of at least one of the charged species, ions or electrons, present in the multipolar magnetic structure and bombarding the substrate (2) that is to be treated.

2.  A method according to claim 1, characterized in that the substrate (2) is electrically insulating.

3.  A method according to claim 1, characterized in that the surface of the substrate (2) is also subjected to the application of a bias voltage.

4.  A method according to any preceding claim, characterized in that it consists in creating, in a manner independent of the means (6) for producing the plasma, two high-energy electron fluxes ($b_1$, $b_2$) each having a current ($I_{b1}$, $I_{b2}$) and an energy that are determined to make it possible to control the energies both of the ions and of the electrons bombarding the surface of the substrate.

5.  A method according to any preceding claim, characterized in that it consists in creating, in a manner independent of the means (6) for producing the plasma, a series of $\underline{n}$ high-energy electron beams ($b_1$, $b_2$, ..., $b_n$), where n > 2, each having a current and an energy that are determined to enable control both of ion energy and of the energy distribution function of the electrons bombarding the substrate.

6.  Apparatus for controlling the bombardment of a substrate subjected to a plasma, the apparatus comprising:

    · a sealed enclosure (3) connected to a pumping circuit (5) and to a feed circuit (4) for feeding a gaseous medium to maintain a determined pressure in the enclosure;
    · means (6) for enabling a plasma to be produced from the gaseous medium; and
    · a multipolar magnetic structure (13) for confining the plasma,

    characterized in that the apparatus comprises at least one source ($7_1$, $7_2$, ..., $7_n$) for producing a flux of high-energy electrons independently of the means (6) for producing the plasma, the electrons being confined by the multipolar structure (13) to bombard the substrate and having current and energy that are determined to control the bias of the surface of the substrate by at least one flux of high-energy electrons bombarding the surface, thus enabling the energy of at least one of the charged species, ions or electrons, present in the multipolar magnetic structure and bombarding the substrate (2) to be controlled.

7.  Apparatus according to claim 6, characterized in that the substrate (2) is insulated in the plasma.

8.  Apparatus according to claim 6, characterized in that the substrate (2) is made of an insulating material, biasing of its surface being controlled by at least one flux of high-energy electrons ($b_1$, $b_2$, ..., $b_n$) bombarding its surface.

9.  Apparatus according to claim 6, characterized in that it includes means for electrically insulating said substrate (2), biasing of its surface being controlled by at least one flux of high-energy electrons ($b_1$, $b_2$, ..., $b_n$) bombarding its surface.

10. Apparatus according to claim 6, characterized in that it includes means for applying a bias voltage to the surface of the substrate (2).

11. Apparatus according to any one of claims 6 to 10, characterized in that it includes two sources ($7_1$, $7_2$) for producing respective high-energy electron fluxes ($b_1$, $b_2$) independently of the means (6) for producing the plasma, with the current ($I_{b1}$, $I_{b2}$) and the energy of the high-energy electrons in the fluxes being determined to enable the energy to be adjusted both of the ions and of the electrons bombarding the substrate.

12. Apparatus according to any one of claims 6 to 10, characterized in that it includes a series of $\underline{n}$ sources ($7_1$, $7_2$, ...,

$7_n$) for producing high-energy electron fluxes, with $n > 2$, independently of the means for producing the plasma, and in which the current and the energy of the high-energy electrons are determined to enable both the energy of the ions and the energy distribution function of the electrons bombarding the substrate to be adjusted.

13. Apparatus according to any one of claims 6 to 12, characterized in that each source for producing a high-energy electron flux ($7_1$, $7_2$, ..., $7_n$) has means for adjusting the current and the energy of its electron flux.

14. Apparatus according to any one of claims 6 to 13, characterized in that each source ($7_1$, $7_2$, ..., $7_n$) produces a flux of high-energy electrons in a manner that is continuous, pulsed, chopped, or modulated.

15. Apparatus according to any one of claims 6 to 14, characterized in that the means (6) for producing the plasma are constituted, at least in part, by the multipolar magnetic confinement structure (13).

16. Apparatus according to claim 15, characterized in that multipolar magnetic structure (13) is excited by a voltage that is direct, low frequency, radiofrequency, or microwave frequency.

17. Apparatus according to claim 15, characterized in that the means (6) for producing the plasma operate by magnetic field coupling at electron cyclotron resonance.

FIG.1

FIG.2

FIG.3

FIG.4

## FIG.5

## FIG.6